(19) Europäisches Patentamt
European Patent Office
Office européen des brevets

(11) EP 0 650 091 B1

(12) # EUROPEAN PATENT SPECIFICATION

(45) Date of publication and mention of the grant of the patent:
**10.03.1999 Bulletin 1999/10**

(51) Int Cl.$^6$: **G03F 7/023**

(21) Application number: **94116403.0**

(22) Date of filing: **18.10.1994**

(54) **Positive photoresist composition**

Positivarbeitende Resistzusammensetzung

Composition pour photoréserve positive

(84) Designated Contracting States:
**BE DE FR GB IT NL SE**

(30) Priority: **19.10.1993 JP 261381/93**

(43) Date of publication of application:
**26.04.1995 Bulletin 1995/17**

(73) Proprietor: **SUMITOMO CHEMICAL COMPANY LIMITED**
**Osaka-shi, Osaka 541-0041 (JP)**

(72) Inventors:
- **Yoshida, Yuji**
  **Minoo-shi (JP)**
- **Osaki, Haruyoshi**
  **Toyonaka-shi (JP)**
- **Hashimoto, Kazuhiko**
  **Ibaraki-shi (JP)**
- **Edamatsu, Kunishige**
  **Toyonaka-shi (JP)**

(74) Representative: **VOSSIUS & PARTNER**
**Siebertstrasse 4**
**81675 München (DE)**

(56) References cited:
**EP-A- 0 415 266**
**EP-A- 0 435 181**
**EP-A- 0 443 607**
**EP-A- 0 461 388**
**EP-A- 0 528 401**
**EP-A- 0 557 991**
**DE-A- 3 839 714**

- **DATABASE WPI Week 8845, Derwent Publications Ltd., London, GB; AN 88-318268 & JP-A-63 234 249 (FUJITSU)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 650 091 B1

Printed by Jouve, 75001 PARIS (FR)

## Description

The present invention relates to a positive resist composition sensitive to radiations such as ultraviolet rays and far ultraviolet rays including excimer laser.

Recently, with a rise in the integration level of integrated circuits, formation of pattern of submicron order is required. As its result, a positive resist composition more excellent in resolution, profile and sensitivity is demanded. Particularly in the production of 16-64 MDRAMs, it is necessary to resolve a pattern having a line width of 0.5 μm or less with a good profile and a good sensitivity.

In Japanese Patent Application KOKAI No. 63-234249, there is mentioned a positive photoresist composition comprising an alkali-soluble novolac resin and a photosensitizer wherein said alkali-soluble novolac resin is a product of a condensation reaction between formaldehyde and a phenol component which is composed of m-cresol, p-cresol and xylenol and contains at least 10% by mole of 3,5-xylenol based on the total phenol component. On the other hand, in Japanese Patent Application KOKAI No. 1-177032, there is mentioned a radiation-sensitive resin composition comprising (A) an alkali-soluble novolac resin which is a co-condensation product of (a) at least one member selected from p-cresol, 2,5-xylenol, 3,5-xylenol and 2,3,5-trimethylphenol, (b) m-cresol and (c) an aldehyde, from which low molecular weight components have been partially removed, (B) at least one member selected from 1,2-quinonediazidesulfonic acid ester of optionally substituted trihydroxybenzophenone, 1,2-quinonediazidesulfonic acid ester of optionally substituted tetrahydroxybenzophenone, 1,2-quinonediazidesulfonic acid ester of optionally substituted pentahydroxybenzophenone and 1,2-quinonediazidesulfonic acid ester of optionally substituted hexahydroxybenzophenone and (C) an optionally substituted polyhydroxybenzophenone, wherein the content of said (C) polyhydroxybenzophenone is 1 to 50 parts by weight per 100 parts by weight of said alkali-soluble novolac resin.

In these compositions, however, a pattern having a line width of 0.5 μm or less cannot be resolved with a good profile and a good sensitivity.

According to the present invention, there is provided a positive photoresist composition excellent in properties such as resolution and profile and good in sensitivity.

The present invention relates to a positive photoresist composition comprising a novolac resin obtainable through a condensation reaction of a mixed cresol component consisting of m-cresol and p-cresol, a mixed xylenol component consisting of 3,5-xylenol and xylenols other than 3,5-xylenol, and an aldehyde component; 1,2-quinonediazide compound; and an alkali-soluble compound the molecular weight of which is lower than 900, wherein, in the condensation reaction, the ratio α of the mixed xylenol component to the sum of the mixed cresol and the mixed xylenol, is not smaller than 10% by mol and not greater than 25% by mol and the ratio β of 3,5-xylenol to the mixed xylenol is not smaller than 20% by mol and not greater than 60% by mol. In this specification, the ratio of the component means the ratio of the component charged in the condensation reaction unless otherwise mentioned. α and β are represented by the following equations:

$$\alpha\ (\%) = \frac{\text{Mol number of the mixed xylenol}}{\text{Total mol number of the mixed cresol and the mixed xylenol}} \times 100$$

$$\beta\ (\%) = \frac{\text{Mol number of 3,5-xylenol}}{\text{Total mol number of the mixed xylenol}} \times 100$$

As preferable novolac resin, novolac resins of which α is not smaller than 15% by mol and not greater than 25% by mol and β is not smaller than 20% by mol and not greater than 50% by mol can be referred to. If α is smaller than 10% by mol, resolution decreases, and if α exceeds 25% by mol, solubility in alkaline developing solution decreases, so that good sensitivity can not be obtained. The ratio of the m-cresol to the mixed cresol is usually not smaller than 30% by mol and not greater than 95% by mol, though it may be appropriately selected in accordance with the kind of the used 1,2-quinonediazide compound.

As xylenol compounds other than 3,5-xylenol which can be used in the present invention, 2,3-xylenol, 2,5-xylenol and 3,4-xylenol can be mentioned, among which 2,5-xylenol is preferable. As examples of the aldehyde compound, formaldehyde, acetaldehyde, benzaldehyde, glyoxal and salicylaldehyde can be mentioned, among which formaldehyde is preferable. These aldehydes can be used singly or in the combination of two or more.

The condensation reaction is carried out in the conventional manner. The reaction temperature is usually 60°C to 120°C, and the reaction time is usually 2 to 30 hours. As the catalyst, inorganic acids such as hydrochloric acid, sulfuric acid and phosphoric acid, organic acids such as oxalic acid, acetic acid and p-toluenesulfonic acid or divalent metal salts such as zinc acetate are used. The condensation reaction is carried out in the presence or absence of a reaction solvent.

The preferable novolac resin used in the positive photoresist composition of the present invention is the one of which the area in the GPC pattern (measured with UV 254 nm detector) of the range in that the molecular weight

as converted to polystyrene is 900 or less is 35% or less based on the total GPC pattern area excluding the pattern areas of unreacted mixed cresol and mixed xylenol, and more preferably the area is 30% or less.

The preferable novolac resin can be obtained by means of, for example, fractionation from the novolac resin formed by the above-mentioned condensation reaction.

The fractionation is effected by dissolving the novolac resin obtained through the condensation reaction in a good solvent such as alcohols (for example, methanol and ethanol), ketones (for example, acetone, methyl ethyl ketone and methyl isobutyl ketone), ethylene glycol ethers, ether esters (for example, ethyl cellosolve acetate) or tetrahydrofuran and subsequently pouring the resulting solution into water to prepare a precipitate, or pouring the solution into a solvent such as pentane, hexane or heptane to separate the solution into two phases.

As preferable 1,2-quinonediazide compound, 1,2-quinonediazidesulfonic acid esters of compounds having at least three phenolic hydroxyl groups can be referred to. As more preferable 1,2-quinonediazide compound, those containing 1,2-quinonediazidesulfonic acid diester in an amount of 50% or more and particularly 80% or more as expressed in terms of pattern area in high performance liquid chromatogram can be referred to.

As the 1,2-quinonediazide compound, those containing 1,2-quinonediazidesulfonic acid esters of dihydric phenol compounds in addition to the 1,2-quinonediazidesulfonic acid esters of compounds having at least three phenolic hydroxyl groups are also usable. In this case, the area of pattern measured by high performance liquid chromatography using UV 254 nm detector of the wholly esterified product, namely the product in which hydroxyl groups are wholly esterified, of dihydric or higher-hydric phenol compounds is preferably 5% or more based on the pattern area of total 1,2-quinonediazide compounds.

As examples of the dihydric and higher-hydric phenol compounds, the compounds represented by the general formula mentioned on Page 3 of Japanese Patent Application KOKAI No. 2-103543, the compounds represented by the general formulas (I) and (II) mentioned in Japanese Patent Application KOKAI No. 2-32352 and the compounds represented by the general formula (I) mentioned in Japanese Patent Application KOKAI No. 2-269351 can be referred to.

As preferable examples of the compound having at least three phenolic hydroxyl groups, oxyflavans including the compound represented by the formula mentioned on Page 4 of Japanese Patent Application KOKAI No. 4-50851 and the oxyflavan compounds represented by the general formula (I) mentioned in Japanese Patent Application KOKAI No. 3-185447 and novolac type reaction products having 3 to 7 phenol nuclei formed by the reaction of phenol compounds and aldehyde compounds can be referred to. Specific examples of said novolac type reaction product include the compounds represented by the following formulas:

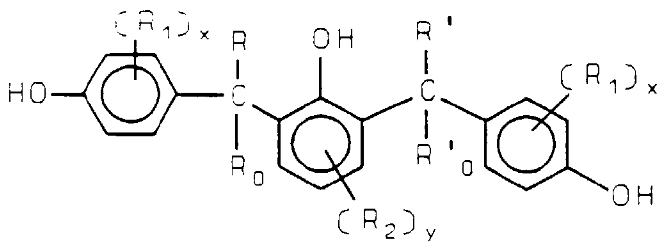

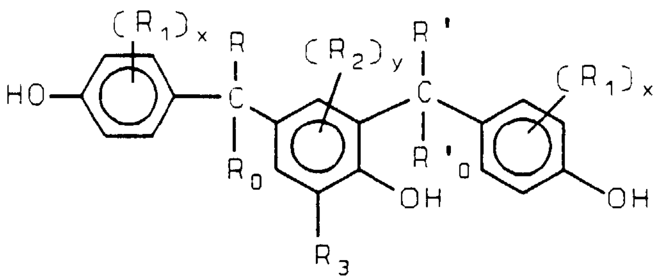

wherein $R_1$ and $R_2$ each independently represents a hydrogen atom, halogen atom, $-OCOR_3$ or optionally substituted alkyl or alkoxy group in which $R_3$ is an optionally substituted alkyl or phenyl group; x and y each independently represents an integer of 1 to 3; and R, $R_0$, R' and $R'_0$ each independently represents a hydrogen atom, alkyl group or phenyl group; and the compounds represented by the following formula:

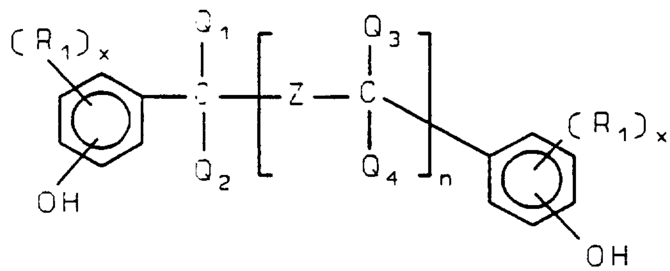

wherein $R_1$ and x are as defined above, $Q_1$ to $Q_4$ each independently represents a hydrogen atom, alkyl group or phenyl group and Z represents a group represented by one of the following formulas:

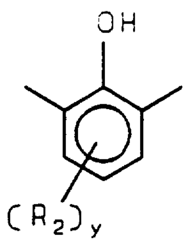

and

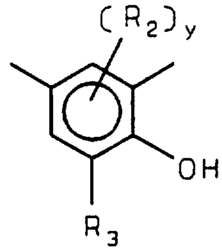

wherein $R_2$, $R_3$ and y are as defined above, and n represents an integer of 2 to 5.

The 1,2-quinonediazide compounds such as the quinonediazidesulfonyl esters of the compounds having at least three phenolic hydroxyl groups and the quinonediazidesulfonyl esters of the dihydric phenol compounds can be produced by, for example, reacting a 1,2-naphtoquinonediazidesulfonyl halide or a 1,2-benzoquinonediazidesulfonyl halide with a compound having at least three phenolic hydroxyl groups or a dihydric phenol compound in the presence of, for example, a weak base.

Preferably, the 1,2-quinonediazide compound is used in an amount of 10 to 50% by weight based on the total solid component in the positive photoresist composition including novolac resin, 1,2-quinonediazide compound and alkali-soluble compound having a molecular weight of lower than 900.

As the alkali-soluble compound having a molecular weight of lower than 900, compounds having at least two phenolic hydroxyl groups are preferred. More preferable alkali-soluble compounds are the compounds represented by the general formula (I) mentioned in Japanese Patent Application KOKAI No. 2-275955, the compounds represented by the general formula (I) mentioned in Japanese Patent Application KOKAI No. 4-50851 and the compounds represented by the general formula (I) mentioned in Japanese Patent Application KOKAI No. 3-179353.

Preferably, the alkali-soluble compound having a molecular weight of lower than 900 is used in an amount of 3 to 40% by weight based on the total solid component in the positive photoresist composition.

If desired, the additives conventionally used in this field of the art such as dye, adhesion-improver and the like may be incorporated in a small amount into the positive photoresist composition of the present invention.

As the solvent used for preparation of a positive photoresist solution, those having an appropriate drying rate and capable of giving a uniform and smooth coating film after evaporation are preferred. Examples of such a solvent include glycol ether esters such as ethyl cellosolve acetate, propylene glycol and monomethyl ether acetate, the solvents mentioned in Japanese patent Application KOKAI 2-220056, esters such as ethyl pyruvate, n-amyl acetate and ethyl lactate, and ketones such as 2-heptanone and γ-butyrolactone. These solvents may be used either independently or in the form of mixture of two or more.

The positive photoresist composition of the present invention can resolve a pattern having a line width of 0.5 μm or less with a good profile with a good sensitivity.

Next, the present invention is explained more concretely with reference to the following examples. The present invention is by no means limited by these examples. In the examples, parts are by weight.

Synthesis Example 1

A three-necked flask having a capacity of 2,000 ml was charged with 116.8 g of m-cresol, 116.8 g of p-cresol, 52.8 g of 2,5-xylenol, 13.2 g of 3,5-xylenol, 266.3 g of methyl isobutyl ketone, 6.9 g of oxalic acid and 91.9 g of 90% acetic acid. The charging ratio of mixed xylenol $\alpha$ was 20% by mol, and the charging ratio of 3,5-xylenol $\beta$ was 20.4% by mol. While heating the mixture in the flask with stirring in an oil bath kept at 100°C, 153.4 g of 37.0% aqueous solution of formaldehyde was dropwise added thereto over a period of 60 minutes and the resulting mixture was reacted for 13 hours. The reaction product was washed with water and dehydrated to obtain 652 g of a solution of a novolac resin in methyl isobutyl ketone. A GPC analysis revealed that the product had a polystyrene-converted weight average molecular weight of 4,176.

Synthesis Examples 2-6

Solutions of a novolac resin in methyl isobutyl ketone were prepared by repeating Synthesis Example 1, except that mol numbers of the charged materials other than m-cresol and p-cresol were as shown in the following tables and the mol numbers of charged m- and p-cresols were the same as those in Synthesis Example 1. The results of GPC analysis are also shown in the following tables.

Table 1

| No. | Mol numbers of Charged materials | | | | 37% Formaldehyde solution (g) | Ratios | |
|---|---|---|---|---|---|---|---|
| | m-Cresol | p-Cresol | 2,5-Xylenol | 3,5-Xylenol | | α (% by mol) | β (% by mol) |
| 2 | 1.08 | 1.08 | 0.43 | 0.22 | 150.4 | 23 | 34 |
| 3 | 1.08 | 1.08 | 0.22 | 0.22 | 137.0 | 17 | 50 |
| 4 | 1.08 | 1.08 | 0.22 | 0.43 | 137.0 | 23 | 66 |
| 5 | 1.08 | 1.08 | 0.61 | 0.04 | 125.4 | 23 | 6 |
| 6 | 1.08 | 1.08 | 0.47 | 0.47 | 119.3 | 30 | 50 |

Table 2

| No. | Yield of resin solution (g) | Weight average molecular weight |
|---|---|---|
| 2 | 573.1 | 4,021 |
| 3 | 541.4 | 4,018 |
| 4 | 501.3 | 4,760 |
| 5 | 575.3 | 4,122 |
| 6 | 834.8 | 4,103 |

Synthesis Example 7

Two hundreds grams of a solution of the novolac resin obtained in Synthesis Example 1 in methyl isobutyl ketone, containing 37.7% by weight of the novolac resin, was charged into a 2-liter flask, to which were further added 177 g of methyl isobutyl ketone and 257 g of n-heptane. The mixture in the flask was stirred at 60°C for 30 minutes, and then left to stand until it separated into two layers. After the separation, 200 g of 2-heptanone was added to the under layer and then the methyl isobutyl ketone and n-heptane were removed therefrom by means of evaporator to obtain a solution of the novolac resin in 2-heptanone. The novolac resin had a polystyrene-converted weight average molecular weight of 6,983 as measured by GPC. The area of the pattern of a range in that the polystyrene-converted molecular weight was 900 or below in the novolac resin was 21% based on the total pattern area.

Synthesis Examples 8-12

Solutions of novolac resin in 2-heptanone were prepared by repeating the procedure of Synthesis Example 7, except that each of the solutions of novolac resin in methyl isobutyl ketone obtained in Synthesis Examples 2 to 6 was charged in the amount shown in the Table 3. The results of GPC analysis are also shown in Table 3. In Table 3, MBK, HP and 2HT are abbreviations of methyl isobutyl ketone, n-heptane and 2-heptanone, respectively.

Table 3

| No. | Resin content (%) | Charge | | | Yield of resin/2HT solution (g) | Weight average molecular weight | Area ratio of the range in which molecular weight is lower than 900 (%) |
|---|---|---|---|---|---|---|---|
| | | MBK solution (g) | Amount of MBK (g) | Amount of HP (g) | | | |
| 8 | 42.6 | 200 | 225.9 | 290.2 | 86.0 | 6,641 | 23 |
| 9 | 42.9 | 200 | 229.3 | 292.6 | 93.9 | 7,095 | 19 |
| 10 | 46.4 | 200 | 263.6 | 315.9 | 125.6 | 7,635 | 17 |
| 11 | 46.3 | 200 | 263.0 | 315.5 | 118.9 | 7,012 | 19 |
| 12 | 44.8 | 200 | 248.0 | 305.3 | 100.9 | 6,894 | 21 |

Examples 1-3 and Comparative Examples 1-3

According to the formulation shown in Tables 4 and 5, a novolac resin (abbreviated to "Resin"), a 1,2-quinonediazide compound (abbreviated to "Photosensitizer") and an alkali-soluble compound (abbreviated to "Additive") were mixed and dissolved in 50 parts of 2-heptanone.

Each solution thus obtained was filtered with a Teflon filter having a pore size of 0.2 μm to prepare a resist solution. By means of a spin coater, the resist solution was coated onto a silicon wafer having been washed in the conventional manner up to a thickness of 1.1 μm, after which the coat was heated at 90°C for one minute on a hot plate. Then, the wafer thus coated was exposed to light by means of a reduction projection exposing machine having a exposing wavelength of 365 nm (i line) (NSR1755i7A, NA=0.5, manufactured by Nikon Corp.), while stepwise changing the amount of exposure.

Subsequently, the wafer was heated on a hot plate at 110°C for one minute, and then developed with SOPD (developing solution, manufactured by Sumitomo Chemical Co., Ltd.) for one minute to obtain a positive pattern. The resolution was evaluated by measuring, with a scanning electron microscope, the dimension of line-and-space pattern which could be resolved without film thickness decrease at an exposure amount giving a line-and-space pattern of 1:1 (effective sensitivity). The profile was evaluated by observing the cross-sectional shape of 0.45 μm line-and-space pattern at an effective sensitivity.

Table 4

| Example No. | Formulation of resist | | | DARK FIELD | | | BRIGHT FIELD | | |
|---|---|---|---|---|---|---|---|---|---|
| | Resin (Synthesis Example No.) | Additive C | Photo-sensitizer (parts) | Effective sensitivity (msec) | Resolution (μm) | Profile | Effective sensitivity (msec) | Resolution (μm) | Profile |
| 1 | 10.23 parts (7) | 3.9 parts | A 0.6<br>B 3.66 | 280 | 0.375 | 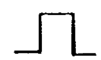 | 300 | 0.400 | 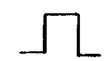 |
| 2 | 10.23 parts (8) | 3.9 parts | A 0.6<br>B 3.66 | 260 | 0.400 | 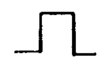 | 300 | 0.400 | 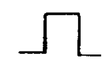 |
| 3 | 10.23 parts (9) | 3.9 parts | A 0.6<br>B 3.66 | 280 | 0.400 | 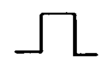 | 320 | 0.400 | 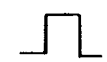 |

Table 5

| Comparative Example No. | Formulation of resist | | | DARK FIELD | | | BRIGHT FIELD | | |
|---|---|---|---|---|---|---|---|---|---|
| | Resin (Synthesis Example No.) | Additive C | Photo-sensitizer (parts) | Effective sensitivity (msec) | Resolution (μm) | Profile | Effective sensitivity (msec) | Resolution (μm) | Profile |
| 1 | 10.23 parts (10) | 3.9 parts | A 0.6<br>B 3.66 | 360 | 0.375 | 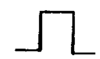 | 420 | 0.400 | 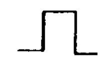 |
| 2 | 10.23 parts (11) | 3.9 parts | A 0.6<br>B 3.66 | 260 | 0.450 | 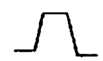 | 330 | 0.450 | 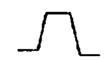 |
| 3 | 10.23 parts (12) | 3.9 parts | A 0.6<br>B 3.66 | 480 | 0.375 | 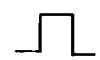 | 500 | 0.400 | 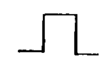 |

In Tables 4 and 5, Additive C is an alkali-soluble compound having a molecular weight of lower than 900, which is represented by the following formula:

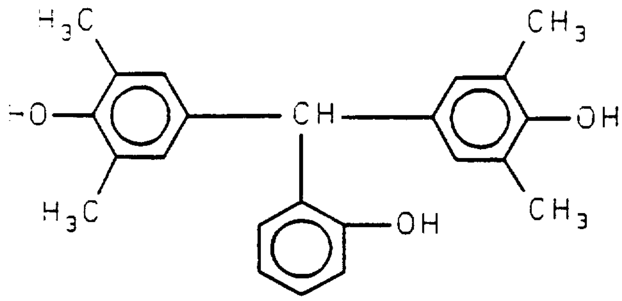

In Tables 4 and 5, Photosensitizers B and A are the compounds represented by the following formulas, respectively:

B:

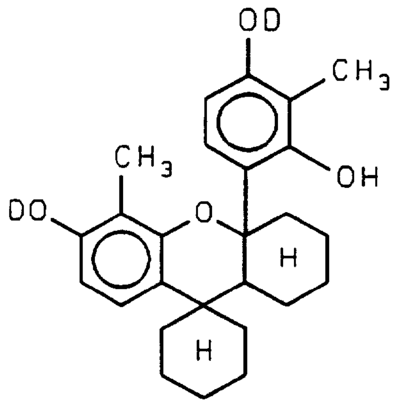

A:

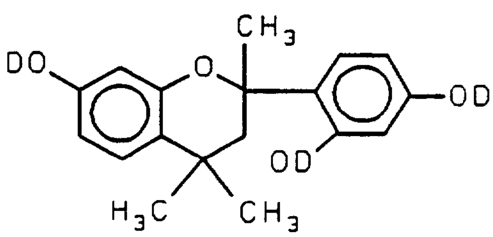

wherein D is 1,2-naphthoquinonediazide-5-sulfonyl group.

**Claims**

1. A positive photoresist composition comprising a novolac resin obtainable through a condensation reaction of a mixed cresol component consisting of m-cresol and p-cresol, a mixed xylenol component consisting of 3,5-xylenol and xylenols other than 3,5-xylenol and an aldehyde compound; a 1,2-quinonediazide compound; and an alkali-soluble compound the molecular weight of which is lower than 900, wherein, in said condensation reaction, the ratio α of the mixed xylenol based on the sum of the mixed cresol and the mixed xylenol is not smaller than 10% by mol and not greater than 25% by mol and the ratio β of 3,5-xylenol in the mixed xylenol is not smaller than 20% by mol and not greater than 60% by mol.

2. A positive photoresist composition according to Claim 1, wherein the GPC pattern area of the novolac resin of the range in which the molecular weight as converted to polystyrene is 900 or less is 35% or less based on the total pattern area excluding the pattern areas of the unreacted mixed cresol and mixed xylenol.

3. A positive photoresist composition according to Claim 1 or 2, wherein said xylenol other than 3,5-xylenol is 2,5-xylenol.

4. A positive photoresist composition according to Claim 1, 2 or 3, wherein said alkali-soluble compound the molecular weight of which is lower than 900 is a compound having at least two phenolic hydroxyl groups.

5. A positive photoresist composition according to Claim 1, 2, 3 or 4, wherein the content of the alkali-soluble compound the molecular weight of which is lower than 900 is 3 to 40 parts by weight per 100 parts by weight of the sum of the novolac resin, 1,2-quinonediazide compound and alkali-soluble compound the molecular weight of which is lower than 900.

## Patentansprüche

1. Positiv arbeitende Photoresistzusammensetzung, umfassend ein Novolakharz, erhältlich durch eine Kondensationsreaktion eines gemischten Cresolbestandteils, bestehend aus m-Cresol und p-Cresol, eines gemischten Xylenolbestandteils, der aus 3,5-Xylenol und von 3,5-Xylenol verschiedenen Xylenolen besteht, und einer Aldehydverbindung; eine 1,2-Chinondiazidverbindung, und eine alkalilösliche Verbindung mit einem Molekulargewicht unter 900, wobei in der Kondensationsreaktion der Anteil $\alpha$ des gemischten Xylenols bezogen auf die Summe des gemischten Cresols und des gemischten Xylenols nicht kleiner als 10 mol-% und nicht größer als 25 mol-% ist und der Anteil $\beta$ des 3,5-Xylenols im gemischten Xylenol nicht kleiner als 20 mol-% und nicht größer als 60 mol-% ist.

2. Positiv arbeitende Photoresistzusammensetzung nach Anspruch 1, in der die Fläche des GPC-Pattern des Novolakharzes des Bereichs, in dem das Molekulargewicht umgerechnet auf Polystyrol, 900 oder weniger beträgt, 35 % oder weniger, bezogen auf die Gesamtfläche des Pattern, ausschließlich der Patternfläche des unreagierten gemischten Cresols und gemischten Xylenols, beträgt.

3. Positiv arbeitende Photoresistzusammensetzung nach Anspruch 1 oder 2. in der das von 3,5-Xylenol verschiedene Xylenol 2,5-Xylenol ist.

4. Positiv arbeitende Photoresistzusammensetzung nach Anspruch 1, 2 oder 3, in der die alkalilösliche Verbindung. von der das Molekulargewicht geringer als 900 ist, eine Verbindung mit mindestens zwei phenolischen Hydroxylgruppen ist.

5. Positiv arbeitende Photoresistzusammensetzung nach Anspruch 1, 2, 3 oder 4, in der der Gehalt der alkalilöslichen Verbindung. mit einem Molekulargewicht unter 900, 3 bis 40 Gev.-Teile, pro 100 Gew.-Teile der Summe des Novolakharzes. der 1,2-Chinondiazidverbindung und der alkalilöslichen Verbindung, mit einem Molekulargewicht unter 900 beträgt.

## Revendications

1. Composition de photoresist positif, comprenant une résine novolaque pouvant être obtenue par une réaction de condensation d'un constituant crésol mixte constitué par du m-crésol et du p-crésol, d'un constituant xylénol mixte constitué par du 3,5-xylénol et des xylénols autres que le 3,5-xylénol, et d'un composé aldéhyde ; un composé 1,2-quinonediazide ; et un composé soluble dans un alcali, dont le poids moléculaire est inférieur à 900, réaction de condensation dans laquelle le rapport $\alpha$ du xylénol mixte sur la base de la somme du crésol mixte et du xylénol mixte n'est pas inférieur à 10 % en moles et pas supérieur à 25 % en moles, et le rapport $\beta$ du 3,5-xylénol dans le xylénol mixte n'est pas inférieur à 20 % en moles et pas supérieur à 60 % en moles.

2. Composition de photoresist positif selon la revendication 1, dans laquelle l'aire de spectre de chromatographie GPC de la résine novolaque de la gamme dans laquelle le poids moléculaire tel que converti au polystyrène est de 900 ou moins est de 35 % ou moins sur la base de l'aire de spectre totale, à l'exclusion des aires de spectre

du crésol mixte et du xylénol mixte non réagis.

**3.** Composition de photoresist positif selon la revendication 1 ou 2, dans laquelle ledit xylénol autre que le 3,5-xylénol est le 2,5-xylénol.

**4.** Composition de photoresist positif selon la revendication 1, 2 ou 3, dans laquelle ledit composé soluble dans un alcali dont le poids moléculaire est inférieur à 900 est un composé ayant au moins deux groupes hydroxyles phénoliques.

**5.** Composition de photoresist positif selon la revendication 1, 2, 3 ou 4, dans laquelle la teneur en composé soluble dans un alcali, dont le poids moléculaire est inférieur à 900, est de 3 à 40 parties en poids pour 100 parties en poids de la somme de la résine novolaque, du composé 1,2-quinonediazide et du composé soluble dans un alcali dont le poids moléculaire est inférieur à 900.